# EUROPEAN PATENT APPLICATION

(11) **EP 4 657 095 A2**
(43) Date of publication of application: **03.12.2025**
(21) Application number: 25208970.1
(22) Date of filing: 15.10.2025
(51) Int. Cl.: G01R 31/367, G01R 31/387

(54) **METHOD AND DEVICE FOR DETECTING BATTERY STATE OF CHARGE**

(30) Priority: 07.11.2024 CN 202411587253
(71) Applicant: Zhejiang Jinko Energy Storage Co., Ltd., Jiaxing, Zhejiang 314415 (CN)
(72) Inventor: CAO, Baojian, Zhejiang, 314415 (CN); JIANG, Junjie, Zhejiang, 314415 (CN)
(74) Representative: Schwarz & Partner Patentanwälte GmbH

(57) **Abstract**

Disclosed are a method and a device for detecting a battery state of charge (SOC), and a computer equipment. The method includes: constructing a first battery-SOC detecting model by taking first sample data without battery-SOC label as a first training data set; constructing a second battery-SOC detecting model according to the feature encoder; constructing second sample data carrying battery-SOC label based on historical operation sampling data of the battery extracted from the full historical operation data of the battery, and extracting features from the second sample data through the feature encoder to obtain sample feature data; iteratively optimizing a feature predictor of the second battery-SOC detecting model by taking the sample feature data as a second training data set, and using an iteratively optimized second battery-SOC detecting model as a target battery-SOC detecting model; and detecting the battery SOC of a to-be-detected battery based on the target battery-SOC detecting model.

## Description

### TECHNICAL FIELD

The present invention relates to the technical field of testing energy storage battery, and in particular to a method and a device for detecting a battery State of Charge (SOC), a computer equipment, a non-transitory computer-readable storage medium, and a computer program product.

### BACKGROUND

The battery State of Charge (SOC), also known as the remaining power, is used to reflect the remaining capacity of the battery. The battery SOC is numerically defined as a ratio of the remaining capacity to the battery capacity and often expressed by a percentage. An accurate detection of the battery SOC is important for ensuring the battery reliability. With the continuous development of science and technology, more and more methods for detecting a battery SOC are emerging.

Currently, an ampere-hour integration method, an equivalent circuit method, or a method based on a neural network model is usually used for detecting the battery SOC. However, due to complex operating conditions of the battery during use, the ampere-hour integration method and the equivalent circuit method cannot truly reflect external characteristics of a battery cell under complex operating conditions, and it is also difficult for the number of labelled samples used by the neural network model to cover the data under all operating conditions, thus making it most likely for a detected battery SOC to be inconsistent with a real SOC. Therefore, the current battery-state-of-charge (battery-SOC) detection has low detection accuracy.

### SUMMARY

In view of the technical problems above, it is necessary to provide a method and a device for detecting a battery State of Charge (SOC), a computer equipment, a non-transitory computer readable storage medium, and a computer program product to improve detection accuracy of a battery-SOC detection.

In a first aspect, the present invention provides a method for detecting a battery SOC, including: constructing a first battery-state-of-charge (battery-SOC) detecting model which characterizes battery operation characteristic changing over time, by taking first sample data without battery-SOC label as a first training data set, wherein the first sample data is generated based on full historical operation data of the battery, and the full historical operation data of the battery include operation data of the battery in a charging stage, in a discharging stage and in an idle stage during historical operation processes, and the first battery-SOC detecting model includes a feature encoder; constructing a second battery-SOC detecting model according to the feature encoder; constructing second sample data carrying battery-SOC label based on historical operation sampling data of the battery extracted from the full historical operation data of the battery, and extracting features from the second sample data through the feature encoder to obtain sample feature data; iteratively optimizing a feature predictor of the second battery-SOC detecting model by taking the sample feature data as a second training data set, and using the iteratively optimized second battery-SOC detecting model as the target battery-SOC detecting model, wherein the target battery-SOC detecting model is configured to characterize a correlation between battery SOC and battery operation characteristic; and detecting the battery SOC of a to-be-detected battery based on the target battery-SOC detecting model.

In an embodiment, constructing the first battery-SOC detecting model which characterizes the operation characteristics of the battery changing over time, by taking the first sample data without battery-SOC label as the first training data set includes: splitting the first training data set into first training data of a first time step and second training data of a second time step, wherein the first time step is less than the second time step; performing a feature reconstruction on the first training data to obtain reconstructed training data; and constructing the first battery-SOC detecting model based on a target training data set composed of the second training data and the reconstructed training data.

In an embodiment, constructing the second sample data carrying battery-SOC label based on the historical operation sampling data of the battery extracted from the full historical operation data of the battery includes: extracting the historical operation sampling data of the battery from the full historical operation data of the battery according to a plurality of battery operating conditions corresponding to the full historical operation data of the battery; determining historical battery States of Charge (SOCs) corresponding to the historical operation sampling data of the battery according to a preset ampere-hour integral ratio; and splicing the historical operation sampling data of the battery and the historical battery SOCs to obtain the second sample data.

In an embodiment, extracting the historical operation sampling data of the battery from the full historical operation data of the battery according to the plurality of battery operating conditions corresponding to the full historical operation data of the battery includes: extracting historical operation-condition data of the battery corresponding to each battery operating condition from the full historical operation data of the battery; sampling multiple operation-condition sample data of the battery from the historical operation-condition data of the battery according to operation-condition-sample weights corresponding to the plurality of battery operating conditions; and integrating the operation-condition sample data of the battery to obtain the historical operation sampling data of the battery.

In an embodiment, the feature encoder includes a plurality of local feature encoders, and each local feature encoder is trained by local sample data of locations of battery cells arranged in a battery module. Extracting the features from the second sample data through the feature encoder to obtain the sample feature data includes: extracting multi-scale features from the second sample data through each local feature encoder according to the locations of the battery cells arranged in the battery module to obtain a plurality of sample spatial scale features, wherein the second sample data include operation characteristics of different battery cells, and one spatial scale corresponds to one battery cell; and performing a weighted fusion on the plurality of sample spatial scale features to obtain the sample feature data.

In an embodiment, before constructing the first battery-SOC detecting model which characterizes the battery operation characteristic changing over time, by taking the first sample data without battery-SOC label as the first training data set, the method further includes: extracting historical operation currents, historical operation voltages, and historical operation temperatures of each battery cell from the full historical operation data of the battery; generating historical sample operation temperatures of each battery cell based on the historical operation temperatures; splicing the historical operation currents, the historical operation voltages, and the historical sample operation temperatures of each battery cell to obtain single-cell sample data of each battery cell; and integrating the single-cell sample data of battery cells to obtain the first sample data.

In an embodiment, generating the historical sample operation temperatures of each battery cell based on the historical operation temperatures includes: selecting the highest historical operation temperature and the lowest historical operation temperature from the historical operation temperatures of each battery cell, and using an average value of the highest historical operation temperature and the lowest historical operation temperature as the historical sample operation temperature of each battery cell.

In an embodiment, constructing the second battery-SOC detecting model according to the feature encoder includes: composing the second battery-SOC detecting model by the feature encoder and an untrained feature predictor.

In an embodiment, iteratively optimizing the feature predictor of the second battery-SOC detecting model by taking the sample feature data as the second training data set, and using the iteratively optimized second battery-SOC detecting model as the target battery-SOC detecting model, include: taking the sample feature data as the second training data set, and iteratively optimizing the feature predictor of the second battery-SOC detecting model through the second training data set; determining that an iterative optimization of the second battery-SOC detecting model is completed until a training of the feature predictor of the second battery-SOC detecting model is completed; and using the iteratively optimized second battery-SOC detecting model as the target battery-SOC detecting model, wherein the target battery-SOC detecting model is configured to characterize a correlation between battery SOC and battery operation characteristic.

In an embodiment, detecting the battery SOC of the to-be-detected battery based on the target battery-SOC detecting model, includes: extracting features from real-time operation data of the to-be-detected battery to obtain battery real-time operation characteristics of the to-be-detected battery according to the target battery-SOC detecting model, and detecting the battery SOC of the to-be-detected battery based on the battery real-time operation characteristics.

In an embodiment, splitting the first training data set into the first training data of the first time step and the second training data of the second time step, includes: splitting the first training data set into the first training data of the first time step and the second training data of the second time step according to time identifiers of data in the first training data set, wherein the first time step is less than the second time step.

In an embodiment, constructing the first battery-SOC detecting model based on the target training data set composed of the second training data and the reconstructed training data includes: composing the target training data set by the second training data and the reconstructed training data; iteratively optimizing a preset battery-SOC detecting model based on the target training data set; and using the optimized preset battery-SOC detecting model as the first battery-SOC detecting model.

In an embodiment, determining the historical battery SOCs corresponding to the historical operation sampling data of the battery according to the preset ampere-hour integral ratio includes: defining a battery SOC corresponding to historical operation sampling data of a fully charged highest-node battery cell to be 100%, and deducing backwards the historical operation sampling data of battery cells in different nodes by using an ampere-hour integration method, to obtain the historical battery SOCs corresponding to different historical operation sample data.

In an embodiment, the plurality of battery operating conditions include a battery charging condition, a battery idle condition, and a battery discharging condition.

In an embodiment, the second sample data include a single-cell voltage of each battery cell, a current of each battery cell, an average temperature of each battery cell, and the battery-SOC label.

In an embodiment, the full historical operation data of the battery include a charging start time, a charging end time, a charging current, a charging voltage, a temperature during charging, a discharge start time, a discharge end time, a discharge current, a discharge voltage, a depth of discharge, and a voltage and a current during the idle stage.

In an embodiment, a data size of the first training data and a data size of the second training data are the same.

In a second aspect, the present invention provides a device for detecting a battery state of charge (SOC), including: a first construction module, a second construction module, an extraction module, an optimization module, and a detection module.

The first construction module is configured to construct a first battery-SOC detecting model which characterizes battery operation characteristic changing over time by taking first sample data without battery-SOC label as a first training data set, wherein the first sample data is generated based on full historical operation data of the battery, and the full historical operation data of the battery include operation data of the battery in a charging stage, in a discharging stage and in an idle stage during historical operation processes, and the first battery-SOC detecting model includes a feature encoder.

The second construction module is configured to construct a second battery-SOC detecting model according to the feature encoder.

The extraction module is configured to construct second sample data carrying battery-SOC label based on historical operation sampling data of the battery extracted from the full historical operation data of the battery, and extract features from the second sample data through the feature encoder to obtain sample feature data.

The optimization module is configured to iteratively optimize a feature predictor of the second battery-SOC detecting model by taking the sample feature data as a second training data set, and use the iteratively optimized second battery-SOC detecting model as the target battery-SOC detecting model, wherein the target battery-SOC detecting model is configured to characterize a correlation between battery SOC and battery operation characteristic.

The detection module is configured to detect the battery SOC of a to-be-detected battery based on the target battery-SOC detecting model.

The first construction module is further configured to: split the first training data set into first training data of a first time step and second training data of a second time step, wherein the first time step is less than the second time step; perform a feature reconstruction on the first training data to obtain reconstructed training data; and construct the first battery-SOC detecting model based on a target training data set composed of the second training data and the reconstructed training data.

The extraction module is further configured to: extract the historical operation sampling data of the battery from the full historical operation data of the battery according to a plurality of battery operating conditions corresponding to the full historical operation data of the battery; determine historical battery SOCs corresponding to the historical operation sampling data of the battery according to a preset ampere-hour integral ratio; and splice the historical operation sampling data of the battery and the historical battery SOCs to obtain the second sample data.

The feature encoder includes a plurality of local feature encoders, and each local feature encoder is trained by local sample data of locations of battery cells arranged in a battery module. The extraction module is further configured to: extract multi-scale features from the second sample data through each local feature encoder according to the locations of the battery cells arranged in the battery module to obtain a plurality of sample spatial scale features, wherein the second sample data include operation characteristics of different battery cells, and one spatial scale corresponds to one battery cell; and perform a weighted fusion on the plurality of sample spatial scale features to obtain the sample feature data.

In an embodiment, the extraction module is further configured to: extract historical operation-condition data of the battery corresponding to each battery operating condition from the full historical operation data of the battery; sample multiple operation-condition sample data of the battery from the historical operation-condition data of the battery according to operation-condition-sample weights corresponding to the plurality of battery operating conditions; and integrate the operation-condition sample data of the battery to obtain the historical operation sampling data of the battery.

In an embodiment, the device for detecting the battery SOC is further configured to: extract historical operation currents, historical operation voltages, and historical operation temperatures of each battery cell from the full historical operation data of the battery; generate historical sample operation temperatures of each battery cell based on the historical operation temperatures; splice the historical operation currents, the historical operation voltages, and the historical sample operation temperatures of each battery cell to obtain single-cell sample data of each battery cell; and integrate the single-cell sample data of battery cells to obtain the first sample data.

In a third aspect, the present invention further provides a computer equipment, including a memory and a processor. The memory has a computer program stored thereon, and the processor, when executing the computer program, implements steps of: constructing a first battery-SOC detecting model which characterizes battery operation characteristic changing over time, by taking first sample data without battery-SOC label as a first training data set, wherein the first sample data is generated based on full historical operation data of the battery, and the full historical operation data of the battery include operation data of the battery in a charging stage, in a discharging stage and in an idle stage during historical operation processes, and the first battery-SOC detecting model includes a feature encoder; constructing a second battery-SOC detecting model according to the feature encoder; constructing second sample data carrying battery-SOC label based on historical operation sampling data of the battery extracted from the full historical operation data of the battery, and extracting features from the second sample data through the feature encoder to obtain sample feature data; iteratively optimizing a feature predictor of the second battery-SOC detecting model by taking the sample feature data as a second training data set, and using the iteratively optimized second battery-SOC detecting model as the target battery-SOC detecting model, wherein the target battery-SOC detecting model is configured to characterize a correlation between battery SOC and battery operation characteristic; and detecting the battery SOC of a to-be-detected battery based on the target battery-SOC detecting model.

In a fourth aspect, the present invention further provides a non-transitory computer-readable storage medium, having a computer program stored thereon. The computer program, when executed by a processor, causes the processor to implement steps of: constructing a first battery-SOC detecting model which characterizes battery operation characteristic changing over time, by taking first sample data without battery-SOC label as a first training data set, wherein the first sample data is generated based on full historical operation data of the battery, and the full historical operation data of the battery include operation data of the battery in a charging stage, in a discharging stage and in an idle stage during historical operation processes, and the first battery-SOC detecting model includes a feature encoder; constructing a second battery-SOC detecting model according to the feature encoder; constructing second sample data carrying battery-SOC label based on historical operation sampling data of the battery extracted from the full historical operation data of the battery, and extracting features from the second sample data through the feature encoder to obtain sample feature data; iteratively optimizing a feature predictor of the second battery-SOC detecting model by taking the sample feature data as a second training data set, and using the iteratively optimized second battery-SOC detecting model as the target battery-SOC detecting model, wherein the target battery-SOC detecting model is configured to characterize a correlation between battery SOC and battery operation characteristic; and detecting the battery SOC of a to-be-detected battery based on the target battery-SOC detecting model.

In a fifth aspect, the present invention further provides a computer program product, including a computer program. The computer program, when executed by a processor, implements steps of: constructing a first battery-SOC detecting model which characterizes battery operation characteristic changing over time, by taking first sample data without battery-SOC label as a first training data set, wherein the first sample data is generated based on full historical operation data of the battery, and the full historical operation data of the battery include operation data of the battery in a charging stage, in a discharging stage and in an idle stage during historical operation processes, and the first battery-SOC detecting model includes a feature encoder; constructing a second battery-SOC detecting model according to the feature encoder; constructing second sample data carrying battery-SOC label based on historical operation sampling data of the battery extracted from the full historical operation data of the battery, and extracting features from the second sample data through the feature encoder to obtain sample feature data; iteratively optimizing a feature predictor of the second battery-SOC detecting model by taking the sample feature data as a second training data set, and using the iteratively optimized second battery-SOC detecting model as the target battery-SOC detecting model, wherein the target battery-SOC detecting model is configured to characterize a correlation between battery SOC and battery operation characteristic; and detecting the battery SOC of a to-be-detected battery based on the target battery-SOC detecting model.

In the above-mentioned method and device for detecting the battery SOC, the computer equipment, the non-transitory computer-readable storage medium, and the computer program product, firstly, the first sample data without battery-SOC label is generated based on the full historical operation data of the battery, the first battery-SOC detecting model, which characterizes the battery operation characteristic changing over time, is constructed by taking the first sample data as the first training data set, so that the first battery-SOC detecting model, which characterizes the battery operation characteristic changing over time, can be constructed based on the full historical operation data of the battery, and then the second battery-SOC detecting model is constructed through the trained feature encoder, and then historical operation sampling data of the battery are extracted from the full historical operation data of the battery, and the second sample data carrying the battery-SOC label are constructed based on the historical operation sampling data of the battery, that is, the purpose of constructing the second sample data by sampling part of the historical operation sampling data of the battery from the full historical operation data of the battery is achieved, and then the feature encoder is used to extract features from the second sample data to obtain sample feature data. Since the sample feature data carries a battery-SOC label, the sample feature data can characterize the correlation between battery SOC and operation characteristic of the battery cell. Therefore, by using the sample feature data as the second training data set, the feature predictor of the second battery-SOC detecting model may be iteratively optimized, and the iteratively optimized second battery-SOC detecting model is used as the target battery-SOC detecting model. Finally, the battery SOC of the to-be-detected battery is detected by the target battery-SOC detecting model. Since the external characteristics of the battery under full operating conditions can be fully reflected through the full historical operation data of the battery, the operation characteristics of the to-be-detected battery are fully captured through the first battery-SOC detecting model. The correlation between battery SOC and battery operation characteristic is accurately reflected by the target battery-SOC detecting model, so that the objective of detecting the battery SOC of the to-be-detected battery accurately can be realized subsequently based on actual operating conditions of the to-be-detected battery. The present invention solves the technical problem in the related art that the ampere-hour integration method and the equivalent circuit method cannot truly reflect the external characteristics of the battery cell in complex operating conditions due to the complex operating conditions of the battery in use, and the problem that it is difficult for the number of labelled samples used by the neural network model to cover the data under all operating conditions, thus making it most likely for the detected battery SOC to be inconsistent with a real SOC. The present invention improves the detection accuracy of the battery-SOC detection.

### BRIEF DESCRIPTION OF THE DRAWINGS

In order to illustrate the technical solutions of the embodiments of the present disclosure and the prior art more clearly, the drawings needed for the description of the embodiments and the prior art are briefly described hereinafter. Obviously, the drawings described hereinafter are only some embodiments of the present disclosure. For the ordinary skilled in the art, other drawings may be obtained based on these drawings without creative work.
FIG. 1 is a schematic flow chart of a method for detecting a battery SOC according to an embodiment;
FIG. 2 is a schematic view showing an architecture of a first battery-SOC detecting model of a method for detecting the battery SOC according to an embodiment;
FIG. 3 is a schematic view showing an architecture of a target battery-SOC detecting model of a method for detecting the battery SOC according to an embodiment;
FIG. 4 is a schematic flow chart of a method for detecting a battery SOC according to another embodiment;
FIG. 5 is a block diagram showing a structure of a device for detecting a battery SOC according to an embodiment;
FIG. 6 is a view showing an internal structure of a computer equipment according to an embodiment.

### DETAILED DESCRIPTION OF THE EMBODIMENTS

In order to make the above objectives, technical solutions and advantages of the present invention clearer and better understood, the present invention is described in detail hereinafter with reference to the accompanying drawings and embodiments. It should be understood that the specific embodiments described herein are only used to explain the present invention but not intended to limit the present invention.

First of all, it should be understood that a State of Charge (SOC) detection of a lithium battery is usually carried out using methods such as an ampere-hour integration method, an equivalent circuit method or a method based on the neural network model. For example, a battery-state-of-charge (battery-SOC) correction is performed based on special operating conditions such as an idle state or a full charge, or a model simulation and a parameter estimation are performed based on an equivalent circuit model, or a model learning is performed based on a supervised or self-supervised deep learning network. However, the above-mentioned methods for detecting the battery SOCs all have their own disadvantages. The operating conditions involved in the first method are limited, while during the model simulation and parameter estimation, only a small size of Edge data of a few cells can be used, thus reducing the generalization ability of the established model. In addition, the defect of the model learning based on the supervised or self-supervised deep learning network is that a pre-training is not performed by using the full data, which ultimately results in the low detection accuracy of the battery-SOC detection. It can be seen that the above-mentioned methods for detecting the battery SOC cannot adapt to requirements for detecting the battery under complex operating conditions, so that the external characteristics of the battery cell under complex operating conditions cannot be truly reflected, thus making it most likely for the detected battery SOC to be inconsistent with the actual SOC. Therefore, there is an urgent need for a method for detecting the battery SOC, which can improve the detection accuracy of the battery-SOC detection.

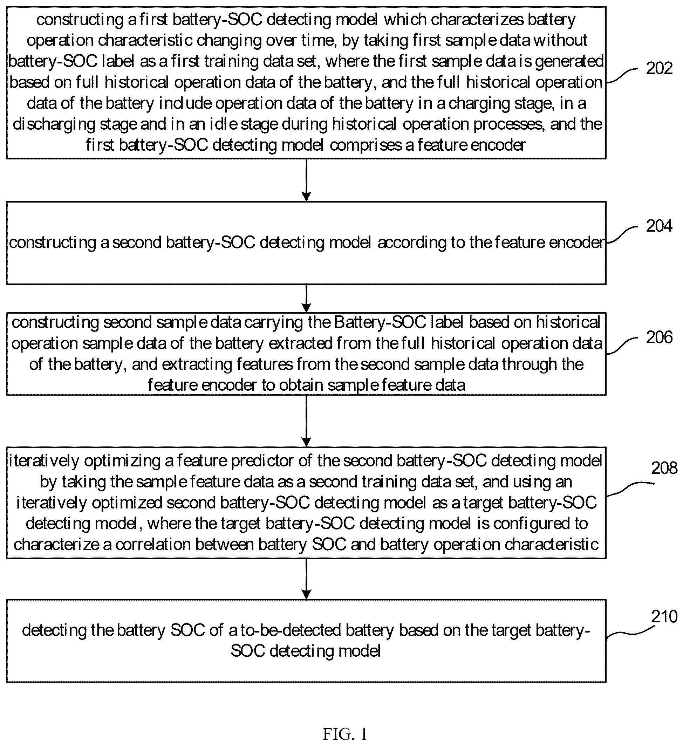

In an embodiment, as shown in FIG. 1, a method for detecting a battery SOC is provided. Taking the method of this embodiment applied to a terminal as an example, the terminal includes but is not limited to a personal computer, a laptop computer, a smart phone, or a tablet computer. The terminal includes a first construction module, a second construction module, an extraction module, an optimization module, and a detection module. The first construction module is configured to, by taking first sample data without battery-SOC label as a first training data set, construct a first battery-SOC detecting model that characterizes battery operation characteristic changing over time. The first sample data is generated according to the full historical operation data of the battery, and the full historical operation data of the battery include all data of the battery in working stages of historical operation processes, and the first battery-SOC detecting model includes a feature encoder. The second construction module is configured to construct a second battery-SOC detecting model according to the feature encoder. The extraction module is configured to construct second sample data carrying battery-SOC label based on historical operation sampling data of the battery extracted from the full historical operation data of the battery, and configured to extract features from the second sample data through the feature encoder to obtain the sample feature data. The optimization module is configured to iteratively optimize a feature predictor of the second battery-SOC detecting model using the sample feature data as a second training data set, and configured to use the iteratively optimized second battery-SOC detecting model as a target battery-SOC detecting model. The target battery-SOC detecting model is configured to characterize a correlation between battery SOC and battery operation characteristic. The detection module is configured to detect the battery SOC of the to-be-detected battery based on the target battery-SOC detecting model.

In the embodiment, in the process of detecting the battery SOC of the to-be-detected battery, firstly, the first battery-SOC detecting model, which characterizes the battery operation characteristic changing over time, is constructed based the first sample data without battery-SOC label, so that the first battery-SOC detecting model, which characterizes the battery operation characteristic changing over time, can be constructed based on the full historical operation data of the battery. Part of historical operation data of the battery is extracted from the full historical operation data of the battery to construct the second sample data. Since the sample feature data carries a battery-SOC label, the sample feature data can characterize the correlation between battery SOC and operation characteristic of the battery cell. Therefore, by using the sample feature data as the second training data set, a feature predictor of the second battery-SOC detecting model may be iteratively optimized, and the iteratively optimized second battery-SOC detecting model is used as the target battery-SOC detecting model. Finally, the battery SOC of the to-be-detected battery is detected by the target battery-SOC detecting model. That is, the external characteristics of the battery under full operating conditions are fully reflected through the full historical operation data of the battery, and the operation characteristics of the to-be-detected battery are fully captured through the first battery-SOC detecting model. The correlation between battery SOC and battery operation characteristic is accurately reflected by the target battery-SOC detecting model, so that the objective of detecting the battery SOC of the to-be-detected battery accurately can be realized subsequently based on actual operating conditions of the to-be-detected battery, thereby solving the technical problem that it is most likely for the detected battery SOC to be inconsistent with the actual SOC when the traditional method for detecting the battery SOC is used for detecting a battery SOC, and improving the detection accuracy of the battery-SOC detection.

The method may also be applied to a server. Alternatively, the method may also be applied to a system including a terminal and a server, and is implemented through an interaction between the terminal and the server. In an embodiment, the method includes the following steps 202 to 210.

In step 202, a first battery-SOC detecting model, which characterizes the battery operation characteristic changing over time, is constructed by taking first sample data without battery-SOC label as a first training data set. The first sample data is generated based on the full historical operation data of the battery, and the full historical operation data of the battery include all operation data of the battery in a charging stage, in a discharging stage and in an idle stage during historical operation processes, and the first battery-SOC detecting model includes a feature encoder.

In an embodiment of the present invention, the terminal is communicatively connected to a cloud server, and the cloud server stores the full historical operation data of the battery. The full historical operation data of the battery refer to all operation data of the battery in the charging stage, in the discharge stage and in the idle stage during the historical operation processes, and may specifically include data in the charging stage, data in the discharge stage, and data in the idle stage (i.e., non-charging and non-discharge stage). For example, the full historical operation data of the battery specifically include a charging start time, a charging end time, a charging current, a charging voltage, a temperature during charging, a discharge start time, a discharge end time, a discharge current, a discharge voltage, a depth of discharge, and a voltage and a current during an idle stage, etc. For example, in an embodiment, before training a model, the Edge uploads signals such as the highest single-cell voltage, single-cell voltages, currents, the highest single-cell temperature, the lowest single-cell temperature, etc. to the cloud, so that the terminal can obtain the first sample data from the cloud subsequently to train the first battery-SOC detecting model.

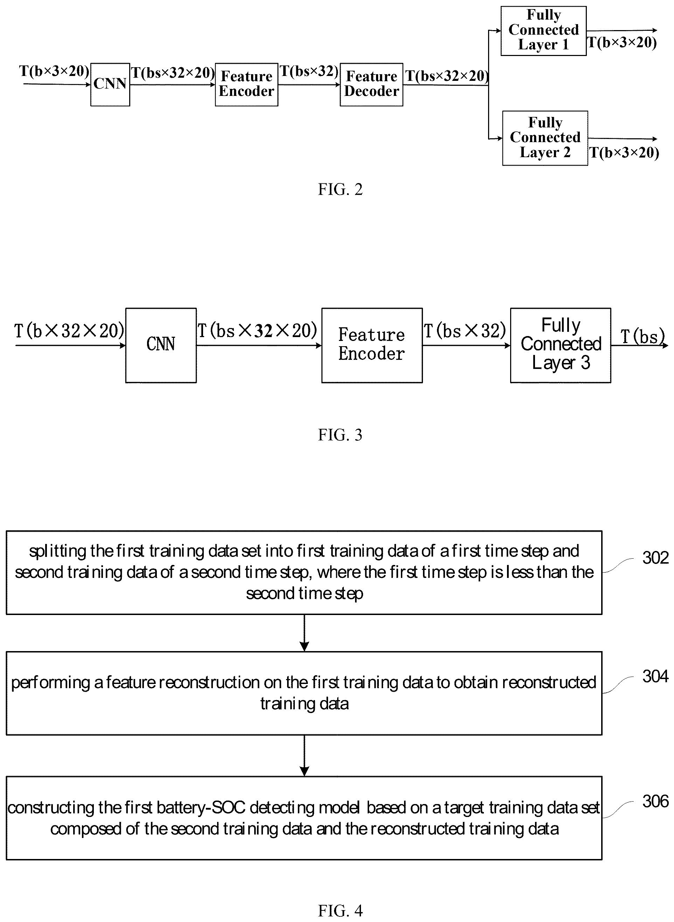

In the process of constructing the first battery-SOC detecting model, unlabeled sample data (the first sample data) generated by the full historical operation data of the battery are used as the first training data set, that is, the full operation characteristics of the battery cell are collected through the first sample data, and then the first battery-SOC detecting model is constructed by the full operation characteristics, so that the first battery-SOC detecting model can accurately capture the external characteristics of the battery. For example, in an implementable embodiment, the terminal accesses the full operating condition data in the cloud database. Assuming that each battery module includes *n* cells connected in series, the single-cell voltage of the battery cell is a data table list having *n* elements. The currents include the current values of all battery cells. The average temperature is an average of the highest single-cell temperature and the lowest single-cell temperature of the battery cell, i.e., a temperature value determined by all battery cells. If the single-cell voltage is separated, a list including three elements for each frame of each battery cell can be obtained: list = [single-cell voltage, current, average temperature]. Therefore, the first sample data generated according to the full historical operation data of the battery can be expressed as "single-cell voltage of the battery cell, current of the battery cell, average temperature of the battery cell", that is, the first sample data may include the single-cell voltage of the battery cell, the current of the battery cell, and the average temperature of the battery cell, which correspond to different historical time frames. The battery-SOC label is configured to identify the battery SOC, which can be 70%, 80% or 90%, etc., that is, the essence of constructing the first battery-SOC detecting model is an unsupervised learning by using the unlabeled full sample data to obtain the battery-SOC detecting model that can accurately capture the battery operation characteristics. For example, in an implementable embodiment, referring to FIG. 2, FIG. 2 is a schematic view showing an architecture of the first battery-SOC detecting model. The first battery-SOC detecting model may include a convolutional neural network (CNN), a feature encoder, a feature decoder, a fully connected layer 1, and the fully connected layer 2. Specifically, the CNN includes convolutional layers and a batch normalization layer combining with an *ReLu* activation function. The feature encoder and the feature decoder both are a two-layer Long Short-Term Memory (LSTM) network. The fully connected layer 1 and the fully connected layer 2 are represented as MLP1 and MLP2, respectively. The preset battery-SOC detecting model is trained by the first training data set to obtain the first battery-SOC detecting model. In the figure, *T* represents a Tensor, *b* represents a batch size. For example, *T (b* × 3 × 20*)* represents that the tensor *T* is a three-dimensional tensor, the first dimension "b " represents the batch size, which is configured to represent the number of samples processed in each iteration, the second dimension "3" represents the number of sample features, and the third dimension "20" represents a time step of each sample.

In an embodiment, step 202 includes: obtaining the full historical operation data of the battery, generating the first sample data without battery-SOC label based on the full historical operation data, and using the first sample data as the first training data set, and iteratively optimizing a preset battery-SOC detecting model, which characterizes the battery operation characteristic changing over time, based on the first training data set to obtain the first battery-SOC detecting model. The first battery-SOC detecting model includes the feature encoder.

In step 204, a second battery-SOC detecting model is constructed according to the feature encoder.

Since the first battery-SOC detecting model is a neural network model that has been trained by the first training data set, the feature encoder of the first battery-SOC detecting model is a trained feature encoder, and the feature encoder can accurately capture the external characteristics of the battery in operation. In an embodiment of the present invention, the second battery-SOC detecting model may be composed of the feature encoder of the first battery-SOC detecting model and an untrained feature predictor.

In an embodiment of the present invention, step 204 includes: composing the second battery-SOC detecting model by the feature encoder and the untrained feature predictor.

In step 206, the second sample data carrying battery-SOC label are constructed based on historical operation sampling data of the battery extracted from the full historical operation data of the battery, and features are extracted from the second sample data through the feature encoder to obtain sample feature data.

The historical operation sampling data of the battery are data extracted from the full historical operation data of the battery, and then the feature encoder extracts the features from the second sample data carrying the battery-SOC label constructed based on the historical operation sampling data of the battery, so as to obtain the sample feature data characterizing the correlation between battery SOC and battery operation characteristic. For example, in an implementable embodiment, among the battery cells in the same battery module, when the highest-node battery cell is fully charged, data of three signals of battery cell of the corresponding node number, which include the single-cell voltage of the battery cell, the current of the battery cell, and the average temperature of the battery cell (namely an average of the highest single-cell temperature and the lowest single-cell temperature), are obtained, thus a data table list including three elements can be obtained for each frame of the highest-node battery cell. In addition, since the highest-node battery cell is fully charged, the battery-SOC label of the highest-node battery cell is defined as "100%". That is, for each historical operation sampling data of the battery obtained through sampling, a corresponding battery-SOC label is defined, thereby forming labeled sample data (i.e., the second sample data). The feature encoder has been trained by the unlabeled sample data, and features are extracted from the second sample data through the feature encoder, and finally the sample feature data are obtained.

In an embodiment of the present invention, step 206 includes: randomly extracting historical operation sampling data of the battery from the full historical operation data of the battery, matching each historical operation sampling data with a battery-SOC label, configuring a battery-SOC label for the corresponding historical operation sampling data of the battery to obtain the second sample data, and inputting the second sample data into the feature encoder, and extracting features to obtain the sample feature data.

In step 208, by taking the sample feature data as the second training data set, the feature predictor of the second battery-SOC detecting model is iteratively optimized, and the iteratively optimized second battery-SOC detecting model is used as the target battery-SOC detecting model, where the target battery-SOC detecting model is configured to characterize the correlation between battery SOC and battery operation characteristic.

The second battery-SOC detecting model refers to a battery-SOC detecting model, in which the feature encoder has been trained but a feature predictor has not been trained. The feature predictor needs to be trained, so that the second battery-SOC detecting model can accurately detect a battery SOC, and then the second battery-SOC detecting model, in which the feature encoder and the feature predictor are trained, is used as the target battery-SOC detecting model. For example, in an implementable embodiment, referring to FIG. 3, FIG. 3 is a schematic view showing an architecture of a target battery-SOC detecting model. The encoder (i.e., a feature encoder) is obtained from the trained first battery-SOC detecting model, and a downstream network (i.e., a fully connected layer 3) is added to form a new model (i.e., a second battery-SOC detecting model). The encoder of the trained first battery-SOC detecting model is frozen, and only the downstream network (i.e., the fully connected layer 3) is trained by the sample feature data, and the second battery-SOC detecting model is iteratively optimized through the second training data set, and the iteratively optimized second battery-SOC detecting model is obtained and saved as the target battery-SOC detecting model.

In an embodiment of the present invention, step 208 includes: taking the sample feature data as a second training data set, iteratively optimizing the feature predictor of the second battery-SOC detecting model through the second training data set, and determining that the iterative optimization of the second battery-SOC detecting model is completed until the training of the feature predictor of the second battery-SOC detecting model is completed, and using the iteratively optimized second battery-SOC detecting model as the target battery-SOC detecting model. The target battery-SOC detecting model is configured to characterize the correlation between battery SOC and battery operation characteristic.

In step 210, the battery SOC of the to-be-detected battery is detected based on the target battery-SOC detecting model.

The target battery-SOC detecting model is configured to characterize the correlation between battery SOC and battery operation characteristic, thus the battery SOC can be predicted by configuring the target battery-SOC detecting model in the Edge.

In an embodiment of the present invention, step 210 includes: extracting features from real-time operation data of the to-be-detected battery to obtain battery real-time operation characteristics of the to-be-detected battery according to the target battery-SOC detecting model, and detecting the battery SOC of the to-be-detected battery based on the battery real-time operation characteristics.

In the above-mentioned method for detecting the battery SOC, firstly, by taking the unlabeled sample data generated based on the full historical operation data of the battery as the first training data set, the preset battery-SOC detecting model that characterizes the battery operation characteristic changing over time is iteratively optimized to obtain the trained first battery-SOC detecting model, and the first battery-SOC detecting model includes a feature encoder. Then, the second battery-SOC detecting model is constructed based on the trained feature encoder, and by taking the labeled sample data as the second training data set, the feature predictor of the second battery-SOC detecting model constructed based on the feature encoder is trained, to obtain the target battery-SOC detecting model, in which both the feature encoder and the feature predictor are trained. Since the target battery-SOC detecting model is configured to characterize the correlation between battery SOC and battery operation characteristic, the battery SOC of the to-be-detected battery can be detected by the target battery-SOC detecting model. Since the full historical operation data of the battery can fully reflect the external characteristics of the battery in all operating conditions, the operation characteristics of the to-be-detected battery can be fully captured by the first battery-SOC detecting model. An accurate feedback for the correlation between battery SOC and battery operation characteristic is given by the target battery-SOC detecting model, that is the battery SOC of the to-be-detected battery can be detected accurately based on the actual operating conditions of the to-be-detected battery. The present invention solves the technical problem in the related art that the ampere-hour integration method and the equivalent circuit method cannot truly reflect the external characteristics of the battery cell in complex operating conditions due to the complex operating conditions of the battery in use, and the problem that it is difficult for the number of labelled samples used by the neural network model to cover the data under all operating conditions, thus making it most likely for the detected battery SOC to be inconsistent with a real SOC. The present invention improves the detection accuracy of the battery-SOC detection.

In an embodiment, as shown in FIG. 4, step S202 of constructing the first battery-SOC detecting model that characterizes the battery operation characteristic changing over time by taking the first sample data without battery-SOC label as the first training data set, includes step 302, step 304 and step 306.

In step 302, the first training data set is split into first training data of a first time step and second training data of a second time step, where the first time step is less than the second time step.

When the full historical operation data of the battery are used to perform a self-supervised pre-training on the preset battery-SOC detecting model, in order to prevent the training from coming into the trap of data self-replication due to a single training task, and in order to prevent the model from lacking insight into the changes in the model in a longer time dimension due to lack of self-prediction, and in order to extract more effective information from the training data to improve the generalization ability of the model, after generating the first training data set based on the full historical operation data, the first data set is split into the first training data and the second training data. The time steps of the first training data and the second training data are different. In order to facilitate the subsequent prediction tasks and self-prediction tasks, the first time step is set to be less than the second time step.

In an embodiment of the present invention, step 302 includes: splitting the first training data set into the first training data of the first time step and the second training data of the second time step according to time identifiers of data in the first training data set, where the first time step is less than the second time step.

In step 304, a feature reconstruction is performed on the first training data to obtain reconstructed training data.

The data size of the first training data and the data size of the second training data may be the same or different. To increase the prediction accuracy and the stability of the model, the first training data are the earlier training data in the first training data set.

In an embodiment of the present invention, step 304 includes: reconstructing the first training data into reconstructed training data.

In step 306, the first battery-SOC detecting model is constructed based on a target training data set composed of the second training data and the reconstructed training data.

In an embodiment of the present invention, step 306 includes: composing the target training data set by the second training data and the reconstructed training data, iteratively optimizing the preset battery-SOC detecting model based on the target training data set, and using the optimized preset battery-SOC detecting model as the first battery-SOC detecting model.

In an embodiment of the present invention, in the process of constructing the first battery-SOC detecting model, firstly, the first training data set is split into first training data and second training data of different time steps, where the time step of the first training data is less than the time step of the second training data, and then the first training data of an earlier time point are used for self-reconstruction to obtain the reconstructed training data, and finally the preset battery-SOC detecting model is iteratively optimized by using the target training data set composed of the second training data and the reconstructed training data, to obtain the first battery-SOC detecting model. Since self-prediction tasks and prediction tasks are involved in the process of iteratively optimizing the preset battery-SOC detecting model, more effective information can be used for the model training in the process of self-supervised learning, thereby improving the generalization ability of the first battery-SOC detecting model.

In an embodiment, constructing the second sample data carrying battery-SOC label based on the historical operation sampling data of the battery extracted from the full historical operation data of the battery in step S206 includes: extracting the historical operation sampling data of the battery from the full historical operation data of the battery according to a plurality of battery operating conditions corresponding to the full historical operation data of the battery; determining the historical battery SOCs corresponding to the historical operation sampling data of the battery according to a preset ampere-hour integral ratio; and splicing the historical operation sampling data of the battery and the historical battery SOCs to obtain the second sample data.

In the process of constructing the second sample data carrying the battery-SOC label, due to the data size of the historical operation sampling data of the battery and the changes in the battery SOC of the historical operation sampling data of the battery in different time frames, the battery-SOC labels may be configured for the historical operation sampling data of the battery in different time frames in a traditional manner. For example, in an implementable embodiment, the battery SOC corresponding to the historical operation sampling data of the fully charged highest-node battery cell may be defined as 100%, and the historical operation sampling data of the battery cells of different nodes may be deduced backwards by using the ampere-hour integration method, to obtain the historical battery SOCs corresponding to different historical operation sample data.

The battery SOCs predicted under different operating conditions are different, and the operating conditions where different batteries are applied are also different. In order to improve the scenario adaptability of the target battery-SOC detecting model, the full historical operation data of the battery can be fixedly extracted based on the battery operating conditions corresponding to the full historical operation data of the battery, so that the historical operation sampling data of the battery can comprehensively and evenly characterize the operation characteristics of the battery under various historical operating conditions. The battery operating conditions may specifically include a battery charging condition, a battery idle condition, and a battery discharging condition, etc. The second sample data may specifically be composed by historical operation sampling data of the battery spliced together with the historical battery SOC. For example, in an implementable embodiment, the second sample data may specifically be "single-cell voltage of the battery cell, current of the battery cell, average temperature of the battery cell, and battery-SOC label of 80%".

In an embodiment, multiple battery operating conditions corresponding to the full historical operation data of the battery are counted, and the historical operating data under different battery historical operating conditions are extracted according to a fixed ratio of battery historical operating conditions to obtain historical operation sampling data of the battery. The corresponding historical battery SOCs are configured for the historical operation sampling data of the battery based on a preset ampere-hour integral ratio. The historical operation sampling data of the battery and the historical battery SOC corresponding to the historical operation sampling data of the battery are spliced together to form the second sample data.

In an embodiment, after counting the multiple battery operating conditions corresponding to the full historical operation data of the battery, the historical operating data under different battery historical operating conditions are extracted as the historical operation sampling data of the battery, and the corresponding historical battery SOCs are configured for different historical operation sampling data of the battery according to the preset ampere-hour integral ratio, so that the second sample data are constructed by splicing the historical operating sample data of the battery and the historical battery SOCs, thereby achieving the effects of quickly configuring the historical battery SOCs for different historical operation sampling data of the battery. In addition, the battery operation characteristics carried by the second sample data can be more adapted to the actual operating scenario of the battery. Therefore, while laying the foundation for improving the detection accuracy of the battery-SOC detection, the present invention also lays the foundation for improving the scenario adaptability of the constructed first battery-SOC detecting model.

In an embodiment, extracting the historical operation sampling data of the battery from the full historical operation data of the battery according to the plurality of battery operating conditions corresponding to the full historical operation data of the battery, includes: extracting the historical operation-condition data of the battery corresponding to each battery operating condition from the full historical operation data of the battery; sampling multiple operation-condition sample data of the battery from the historical operation-condition data of the battery according to operation-condition-sample weights corresponding to the plurality of battery operating conditions; and integrating the operation-condition sample data of the battery to obtain the historical operation sampling data of the battery.

In actual applications, frequencies of occurrence of different battery operating conditions are different. In order to reflect the differences between different battery operating conditions, different operation-condition-sample weights may be matched to the historical operation-condition data of the battery corresponding to different battery operating conditions, and then the historical operation-condition data of the battery are sampled based on the different operation-condition-sample weights to obtain the historical operation sampling data of the battery. In the historical operation sampling data of the battery, the data sizes of the historical operation-condition data corresponding to different battery historical operating conditions are different. For example, in an implementable embodiment, assuming that an operation-condition-sample weight of a battery operating condition *A* is 0.7, an operation-condition-sample weight of a battery operating condition *B* is 0.2, and an operation-condition-sample weight of a battery operating condition *C* is 0.1, then in the integrated historical operation sampling data of the battery, the ratio of the historical operation-condition data of the battery corresponding to the battery operating condition *A,* to the battery operating condition *B,* and to the battery operating condition *C* is 7:2:1.

In an embodiment, the full historical operation data of the battery is divided into historical operation-condition data of the battery corresponding to various battery operating conditions, and a corresponding operation-condition-sample weight is matched to each battery operating condition. Based on the operation-condition-sample weights, a plurality of operation-condition sample data of the battery are sampled from the historical operation-condition data of the battery corresponding to each battery operating condition; and the plurality of operation-condition sample data of the battery under each battery historical operating condition are integrated together to obtain the historical operation sampling data of the battery.

In an embodiment of the present invention, in the process of extracting the historical operation sampling data of the battery from the full historical operation data of the battery, the full historical operation data of the battery are first divided according to the battery operating conditions to obtain the historical operation-condition data of the battery corresponding to different battery operating conditions, and then the historical operation-condition data of the battery corresponding to different battery operating conditions are sampled based on the operation-condition-sample weights corresponding to different battery operating conditions, to obtain the operation-condition sample data of the battery corresponding to multiple battery operating conditions. The operation-condition sample data of the battery corresponding to different battery operating conditions are integrated to obtain the historical operation sampling data of the battery, so as to achieve the purpose of obtaining the historical operation sampling data of the battery by a weighted extraction from the full historical operation data of the battery based on the frequencies of different battery operating conditions in actual applications, thereby further laying a foundation for improving the scenario adaptability of the constructed first battery-SOC detecting model.

In an embodiment, the feature encoder includes a plurality of local feature encoders, each of which is trained by local sample data of locations of the battery cells arranged in the battery module. Extracting features from the second sample data through the feature encoder to obtain the sample feature data in step S206, includes following steps. Each local feature encoder extracts multi-scale features from the second sample data according to the locations of the battery cells arranged in the battery module to obtain a plurality of sample spatial scale features. The second sample data include operation characteristics of different battery cells, and one spatial scale corresponds to one battery cell. A weighted fusion is performed on the sample spatial scale features to obtain sample feature data.

In the process of extracting the features from the second sample data, the battery cells generate different operating data due to different locations of the battery cells arranged in the battery module, in order to fully reflect the external characteristics of the battery cells under historical operating conditions, the local sample data of the battery cells arrange at different locations can be extracted, and multiple local feature encoders are configured in the feature encoder. After the training of the multiple local feature encoders is completed based on the local sample data, the sample space scale features of the battery cells arranged at different locations in the battery module can be extracted through the multiple local feature encoders. Finally, the multiple sample space scales are fused to obtain the sample feature data, so that the operation characteristics of the battery cells can be fully reflected, thereby improving the richness of the sample features, and so that the target battery-SOC detecting model obtained by the subsequent iterative training has stronger generalization ability.

In an embodiment, the multiple local feature encoders perform the multi-scale feature extraction on the second sample data according to the locations of the battery cells arranged in the battery module, to obtain the multiple sample spatial scale features. The second sample data include operation characteristics of different battery cells, one spatial scale corresponds to one battery cell, and the multiple local feature encoders are trained by the local sample data of the locations of the battery cells arranged in the battery module. The spatial scale features of the samples are fused together according to feature weights of the spatial scale features of the samples to obtain the sample feature data.

In this embodiment, in the process of extracting features from the second sample data by using the feature encoder, the configured multiple local feature encoders extract the multi-scale features from the second sample data according to the locations of the battery cells arranged in the battery module, so that the sample spatial scale features at different spatial scales are extracted from the operation characteristics of different battery cells, and finally the different sample spatial scale features are weighted and fused to obtain the sample feature data. The obtained sample feature data can fully reflect the spatial characteristics of the battery cell under the operating conditions, and thus in the process of iteratively optimizing the second battery-SOC detecting model based on the sample feature data, the richness of the sample features can be improved, thereby laying the foundation for improving the detection accuracy of the constructed target battery-SOC detecting model.

In an embodiment, before constructing the first battery-SOC detecting model that characterizes the battery operation characteristic changing over time by taking the first sample data without battery-SOC label as the first training data set, the method further includes: extracting historical operation currents, historical operation voltages, and historical operation temperatures of each battery cell from the full historical operation data of the battery; generating historical sample operation temperatures of each battery cell based on the historical operation temperatures; splicing the historical operation currents, the historical operation voltages, and the historical sample operation temperatures of each battery cell to obtain the single-cell sample data of the corresponding battery cell; and integrating the single-cell sample data of all battery cells to obtain the first sample data.

In a conventional method for detecting the battery SOC, full data are not used, which results in that the conventional method cannot adapted to the complex external characteristics of iron-lithium batteries under various operating conditions. In the embodiments of the present invention, although the full historical operation data of the battery are used to avoid the above defects, the full historical operation data of the battery is huge. In order to improve the detection efficiency of detecting the battery SOC, the full historical operation data of the battery may be preprocessed, and the preprocessed full historical operation data of the battery can be integrated to obtain the first sample data for iteratively training the preset battery-SOC detecting model.

In an embodiment, the historical operation currents, the historical operation voltages, and the historical operation temperatures of each battery cell are extracted from the full historical operation data of the battery; the highest historical operation temperature and the lowest historical operation temperature are selected from the historical operation temperatures, and the average value of the highest historical operation temperature and the lowest historical operation temperature is used as the historical sample operation temperature of the battery cell. For any one of the battery cell, the historical operation currents, the historical operation voltages and the historical sample operation temperature of the battery cell are spliced together to obtain the single-cell sample data of the corresponding battery cell. All of the single-cell sample data are integrated to obtain the first sample data.

In this embodiment, currents, voltages and temperatures are extracted from the full historical operation data of the battery as characteristic data reflecting the operating conditions of the battery, and the currents, voltages and temperatures of different battery cells are integrated to obtain the first sample data for iteratively training the preset battery-SOC detecting model, thereby reducing the redundancy of sample data while adapting to the complex external characteristics of the battery cells under various operating conditions. Therefore, while laying the foundation for improving the detection accuracy of the battery-SOC detection, the method of the present invention also lays a foundation for improving the detection efficiency of detecting the battery SOC.

In an implementable embodiment, the specific procedures of the method for detecting the battery SOC can be as follows. 1) Firstly, the highest single-cell voltage, single-cell voltages, currents, the highest single-cell temperature and the lowest single-cell temperature are obtained from the full historical operation data of the battery in the cloud, and after preprocessing these data, the first sample data without the battery-SOC label are obtained, that is, for each frame of each battery cell, a list including three elements can be obtained: list = [single-cell voltage, current, average temperature]. 2) The time series are sliced and split to form a data set as follows: assume that m denotes a slice length, move frame by frame, if historical data of forward continuous 2m frames, which include a single-cell voltage, a current, and an average temperature, are all valid data, then the forward time series with a dimension of 3×(2m) are intercepted, where the time series of the first *m* frames is denoted as *A1,* and the time series of the next *m* frames is denoted as *A2,* and then the input of a deep learning model MODEL1 (i.e., the first battery-SOC detecting model) of an autoencoder architecture is *A1* having a dimension of 3×m, and output labels are *A1* and *A2,* both of which have a dimension of 3×m. Because all valid data, regardless of charging, discharging or idle data, can be sliced as the input and output of the model MODEL1, the data size is large. The data set is divided as follows: 98% thereof is used for a training set, 1% thereof is used for a verifying set, and 1% thereof is used for a test set. The data set (the first training data set) is denoted as *D1,* and the preset battery-SOC detecting model is iteratively trained by using the data set *D1* to obtain the first battery-SOC detecting model. 3) Access the charging data in the database, and label the battery cells as follows: if the highest-node battery cell in the same battery module is fully charged, obtain three signals of the battery cell of the corresponding node number, which include the single-cell voltage, the current, and the average temperature (an average of the highest cell temperature and the lowest cell temperature), then for each frame of the highest-node battery cell, a list including 3 elements can be obtained. The true SOC label of each frame of the highest-node battery cell is defined as follows: deduce backwards from the full charge point by using the ampere-hour integration, where the full charge point is defined as 100%SOC, that is, the historical battery SOCs of different historical operation sampling data of the battery are determined by using the ampere-hour integration method, and the historical operation sampling data of the battery and the historical battery SOCs are spliced to obtain the second sample data. 4) The time series of the full charge period of the highest-node battery cell mentioned above are sliced and split to form a data set in a manner as follows: move frame by frame, if historical data of the forward continuous m frames, which include a voltage, a current, and an average temperature, are all valid data, then the forward time series with the dimension of 3×(m) are intercepted and denoted as *A3.* Then the input of the SOC intelligent prediction model MODEL2 (i.e., the second battery-SOC detecting model) is A3 with a dimension of 3×m, and the output label is the actual SOC at the current moment. The data set is divided as follows: 70% thereof is used for the training set, 20% thereof is used for the verifying set, and 10% thereof is used for the test set. The data set (the sample feature data) is denoted as *D2,* and the second battery-SOC detecting model is trained by the sample feature data to obtain the target battery-SOC detecting model. That is, by taking the sample feature data as the second training data set, the feature predictor of the second battery-SOC detecting model is iteratively optimized, and the iteratively optimized second battery-SOC detecting model is used as the target battery-SOC detecting model. 5) The trained deep learning model MODEL2 (the target battery-SOC detecting model) is configured in the Edge for an intelligent SOC estimation.

Since the full historical operation data of the battery can fully reflect the external characteristics of the battery under all operating conditions, the operation characteristics of the to-be-detected battery can be fully captured by the first battery-SOC detecting model. An accurate feedback for the correlation between battery SOC and battery operation characteristic is given by the target battery-SOC detecting model, that is the battery SOC of the to-be-detected battery can be detected accurately based on the actual operating conditions of the to-be-detected battery. The present invention solves the technical problems in the related art that the ampere-hour integration method and the equivalent circuit method cannot truly reflect the external characteristics of the battery cell under complex operating conditions due to the complex operating conditions of the battery in use, and the problem that it is difficult for the number of labelled samples used by the neural network model to cover the data under all operating conditions, thus making it most likely for the detected battery SOC to be inconsistent with a real SOC. The present invention improves the detection accuracy of the battery-SOC detection.

It should be understood that, although the steps are displayed sequentially according to the instructions of the arrows in the flowcharts of the embodiments, these steps are not necessarily performed sequentially according to the sequence instructed by the arrows. Unless otherwise explicitly specified in this specification, execution of the steps is not strictly limited, and the steps may be performed in other sequences. Moreover, at least some of the steps in the flowcharts in each embodiment may include a plurality of sub-steps or a plurality of stages. The steps or stages are not necessarily performed at the same moment but may be performed at different moments. Execution of the steps or stages is not necessarily sequentially performed, but may be performed alternately with other steps or at least some of sub-steps or stages of other steps.

Based on the same inventive concepts, an embodiment of the present invention also provides a device for detecting a battery SOC for implementing the method for detecting the battery SOC above. The implementation solutions provided by the device for solving the problem are similar to the implementation solutions described in the above method, so for the specific limitations on one or more embodiments of the device for detecting the battery SOC provided below, please refer to the limitations of the method for detecting the battery SOC above, which will not be described repeatedly herein.

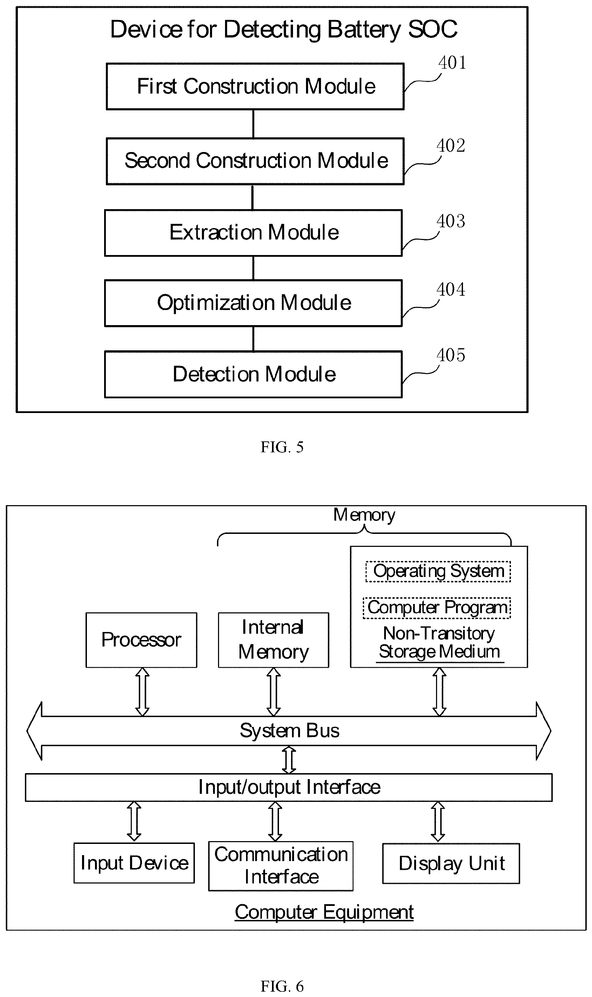

In an exemplary embodiment, as shown in FIG. 5, a device for detecting a battery SOC is provided. The device includes: a first construction module 401, a second construction module 402, an extraction module 403, an optimization module 404, and a detection module 405.

The first construction module 401 is configured to construct a first battery-SOC detecting model which characterizes the battery operation characteristic changing over time by taking first sample data without battery-SOC label as a first training data set. The first sample data is generated based on the full historical operation data of the battery, and the full historical operation data of the battery include all operation data of the battery in a charging stage, in a discharging stage and in an idle stage during historical operation processes, and the first battery-SOC detecting model includes a feature encoder.

The second constructing module 402 is configured to construct a second battery-SOC detecting model according to the feature encoder.

The extraction module 403 is configured to construct second sample data carrying the battery-SOC label based on the historical operation sampling data of the battery extracted from the full historical operation data of the battery, and configured to extract features from the second sample data through the feature encoder to obtain sample feature data.

The optimization module 404 is configured to iteratively optimize the feature predictor of the second battery-SOC detecting model using the sample feature data as a second training data set, and use the iteratively optimized second battery-SOC detecting model as a target battery-SOC detecting model, where the target battery-SOC detecting model is configured to characterize the correlation between battery SOC and battery operation characteristic.

The detection module 405 is configured to detect the battery SOC of the to-be-detected battery based on the target battery-SOC detecting model.

In an embodiment, the first construction module 401 is further configured to: split the first training data set into the first training data of the first time step and the second training data of the second time step, where the first time step is less than the second time step; perform a feature reconstruction on the first training data to obtain reconstructed training data; and construct the first battery-SOC detecting model based on a target training data set composed of the second training data and the reconstructed training data.

In an embodiment, the extraction module 403 is further configured to: extract the historical operation sampling data of the battery from the full historical operation data of the battery according to a plurality of battery operating conditions corresponding to the full historical operation data of the battery; determine the historical battery SOCs corresponding to the historical operation sampling data of the battery according to a preset ampere-hour integral ratio; and splice the historical operation sampling data of the battery and the historical battery SOCs to obtain the second sample data.

In one of the embodiments, the extraction module 403 is further configured to: extract the historical operation-condition data of the battery corresponding to each battery operating condition from the full historical operation data of the battery; sample multiple operation-condition sample data of the battery from the historical operation-condition data of the battery according to operation-condition-sample weights corresponding to the operating conditions of the battery; and integrate the operation-condition sample data of the battery to obtain the historical operation sampling data of the battery.

In one of the embodiments, the feature encoder includes a plurality of local feature encoders, each of which is trained by local sample data of locations of the battery cells arranged in the battery module. The extraction module 403 is further configured to: extract multi-scale features from the second sample data through each local feature encoder according to the locations of the battery cells arranged in the battery module to obtain a plurality of sample spatial scale features, where the second sample data include operation characteristics of different battery cells, and one spatial scale corresponds to one battery cell; and perform a weighted fusion on the sample spatial scale features to obtain sample feature data.

In one of the embodiments, the device for detecting the battery SOC is further configured to: extract historical operation currents, historical operation voltages, and historical operation temperatures of each battery cell from the full historical operation data of the battery; generate historical sample operation temperatures of each battery cell based on the historical operation temperatures; for any one of the battery cells, splice the historical operation currents, the historical operation voltages, and the historical sample operation temperatures of the battery cell to obtain the single-cell sample data of the corresponding battery cell; and integrate all of the single-cell sample data to obtain the first sample data.

Each module of the above-mentioned device for detecting the battery SOC may be implemented in whole or in part by software, hardware, or combinations thereof. The modules may be embedded in or independent of the processor of the computer device in a form of hardware, or may be stored in the memory of the computer device in a form of software to facilitate the processor calling and executing the operations corresponding to each of the above modules.

In an exemplary embodiment, a computer equipment is provided, and the computer equipment may be a server, and an internal structure diagram thereof may be as shown in FIG. 6. The computer equipment includes a processor, a memory, an input/output (I/O) interface, a communication interface, a display unit, and an input device. The processor, the memory and the input/output interface are connected via a system bus. The communication interface, the display unit, and the input device are connected to the system bus via the input/output interface. The processor of the computer equipment is configured to provide computing and control capabilities. The memory of the computer equipment includes a non-transitory storage medium and an internal memory. The non-transitory storage medium stores an operating system and a computer program. The internal memory provides an environment for the operation of the operating system and the computer program in the non-transitory storage medium. The input/output interface of the computer equipment is configured to exchange information between the processor and an external device. The communication interface of the computer device is used to communicate with an external terminal in a wired or wireless manner. The wireless manner can be achieved through WIFI, mobile cellular network, NFC (near field communication) or other technologies. The computer program, when executed by a processor, implements the method for detecting the battery SOC. Those skilled in the art may understand that the structure shown in FIG. 6 is merely a block diagram of partial structure related to the solutions of the present invention, but does not constitute a limitation on the computer device to which the solutions of the present invention is applied. The specific computer device may include more or fewer components than those shown in the figure, or may combine some components, or have a different arrangement of components.

In an embodiment, a computer equipment is further provided. The computer equipment includes a memory and a processor. A computer program is stored in the memory, and the processor, when executing the computer program, implements the steps of the above method embodiments.

In an embodiment, a non-transitory computer-readable storage medium is provided. A computer program is stored on the storage medium. The computer program, when executed by a processor, causes the processor to implement the steps of the above-mentioned method embodiments.

In an embodiment, a computer program product is provided. The computer program product includes a computer program. The computer program, when executed by a processor, implements the steps of the above method embodiments.

A person of ordinary skill in the art may understand that all or some of procedures of the method in the foregoing embodiments may be implemented by a computer program instructing relevant hardware. The program may be stored in a non-transitory computer-readable storage medium. When the program is executed, the procedures of the foregoing method embodiments may be implemented. Any reference to a memory, a storage, a database, or another medium used in the embodiments provided in this invention may include at least one of a non-volatile memory and a volatile memory. The non-volatile memory may include a read-only memory (Read-Only Memory, ROM), a magnetic tape, a floppy disk, a flash memory, an optical memory, a high-density embedded non-volatile memory, a resistive random access memory (ReRAM), a magnetoresistive random access memory (Magnetoresistive Random Access Memory, MRAM), a ferroelectric random access memory (Ferroelectric Random Access Memory, FRAM), a phase change memory (Phase Change Memory, PCM), a graphene memory, and the like. The volatile memory may include a random access memory (RAM) or an external cache. For the purpose of description instead of limitation, the RAM is available in a plurality of forms, such as a static RAM (SRAM) or a dynamic RAM (DRAM). The databases involved in the embodiments provided in this invention may include at least one of a relational database and a non-relational database. The non-relational database may include a blockchain based distributed database or the like, but is not limited thereto. The processor in the embodiments provided in this invention may be a general-purpose processor, a central processing unit, a graphics processing unit, a digital signal processor, a programmable logic device, a quantum computing-based data processing logic device, or the like, and is not limited thereto.

## Claims

1. A method for detecting a battery state of charge (SOC), **characterized by** comprising:
constructing a first battery-state-of-charge (battery-SOC) detecting model which characterizes battery operation characteristic changing over time, by taking first sample data without battery-SOC label as a first training data set, wherein the first sample data is generated based on full historical operation data of the battery, and the full historical operation data of the battery comprise operation data of the battery in a charging stage, in a discharging stage and in an idle stage during historical operation processes, and the first battery-SOC detecting model comprises a feature encoder;
constructing a second battery-SOC detecting model according to the feature encoder;
constructing second sample data carrying the battery-SOC label based on historical operation sampling data of the battery extracted from the full historical operation data of the battery, and extracting features from the second sample data through the feature encoder to obtain sample feature data;
iteratively optimizing a feature predictor of the second battery-SOC detecting model by taking the sample feature data as a second training data set, and using an iteratively optimized second battery-SOC detecting model as a target battery-SOC detecting model, wherein the target battery-SOC detecting model is configured to characterize a correlation between battery SOC and battery operation characteristic; and
detecting the battery SOC of a to-be-detected battery based on the target battery-SOC detecting model.

2. The method according to claim 1, wherein constructing the first battery-SOC detecting model which characterizes the operation characteristics of the battery changing over time, by taking the first sample data without the battery-SOC label as the first training data set comprises:
splitting the first training data set into first training data of a first time step and second training data of a second time step, wherein the first time step is less than the second time step;
performing a feature reconstruction on the first training data to obtain reconstructed training data; and
constructing the first battery-SOC detecting model based on a target training data set composed of the second training data and the reconstructed training data.

3. The method according to claim 2, wherein constructing the second sample data carrying the battery-SOC label based on the historical operation sampling data of the battery extracted from the full historical operation data of the battery comprises:
extracting the historical operation sampling data of the battery from the full historical operation data of the battery according to a plurality of battery operating conditions corresponding to the full historical operation data of the battery;
determining historical battery SOCs corresponding to the historical operation sampling data of the battery according to a preset ampere-hour integral ratio; and
splicing the historical operation sampling data of the battery and the historical battery SOCs to obtain the second sample data.

4. The method according to claim 3, wherein extracting the historical operation sampling data of the battery from the full historical operation data of the battery according to the plurality of battery operating conditions corresponding to the full historical operation data of the battery comprises:
extracting historical operation-condition data of the battery corresponding to each battery operating condition from the full historical operation data of the battery;
sampling multiple operation-condition sample data of the battery from the historical operation-condition data of the battery according to operation-condition-sample weights corresponding to the plurality of battery operating conditions; and
integrating the operation-condition sample data of the battery to obtain the historical operation sampling data of the battery.

5. The method according to any one of claim 1 to 4, wherein the feature encoder comprises a plurality of local feature encoders, and each local feature encoder is trained by local sample data of locations of battery cells arranged in a battery module; wherein extracting the features from the second sample data through the feature encoder to obtain the sample feature data comprises:
extracting multi-scale features from the second sample data through each local feature encoder according to the locations of the battery cells arranged in the battery module to obtain a plurality of sample spatial scale features, wherein the second sample data comprise operation characteristics of different battery cells, and one spatial scale corresponds to one battery cell; and
performing a weighted fusion on the plurality of sample spatial scale features to obtain the sample feature data.

6. The method according to any one of claims 1 to 5, wherein, before constructing the first battery-SOC detecting model which characterizes the battery operation characteristic changing over time, by taking the first sample data without the battery-SOC label as the first training data set, the method further comprises:
extracting historical operation currents, historical operation voltages, and historical operation temperatures of each battery cell from the full historical operation data of the battery;
generating historical sample operation temperatures of each battery cell based on the historical operation temperatures;
splicing the historical operation currents, the historical operation voltages, and the historical sample operation temperatures of each battery cell to obtain single-cell sample data of each battery cell; and
integrating the single-cell sample data of battery cells to obtain the first sample data.

7. The method according to claim 6, wherein generating the historical sample operation temperatures of each battery cell based on the historical operation temperatures comprises: selecting the highest historical operation temperature and the lowest historical operation temperature from the historical operation temperatures of each battery cell, and using an average value of the highest historical operation temperature and the lowest historical operation temperature as the historical sample operation temperature of each battery cell.

8. The method according to any one of claims 1 to 7, wherein iteratively optimizing the feature predictor of the second battery-SOC detecting model by taking the sample feature data as the second training data set, and using the iteratively optimized second battery-SOC detecting model as the target battery-SOC detecting model, comprise:
taking the sample feature data as the second training data set, and iteratively optimizing the feature predictor of the second battery-SOC detecting model through the second training data set;
determining that an iterative optimization of the second battery-SOC detecting model is completed until a training of the feature predictor of the second battery-SOC detecting model is completed; and
using the iteratively optimized second battery-SOC detecting model as the target battery-SOC detecting model, wherein the target battery-SOC detecting model is configured to characterize a correlation between battery SOC and battery operation characteristic.

9. The method according to any one of claims 1 to 8, wherein detecting the battery SOC of the to-be-detected battery based on the target battery-SOC detecting model, comprises:
extracting features from real-time operation data of the to-be-detected battery to obtain battery real-time operation characteristics of the to-be-detected battery according to the target battery-SOC detecting model; and
detecting the battery SOC of the to-be-detected battery based on the battery real-time operation characteristics.

10. The method according to any one of claims 1 to 9, wherein splitting the first training data set into the first training data of the first time step and the second training data of the second time step, comprises: splitting the first training data set into the first training data of the first time step and the second training data of the second time step according to time identifiers of data in the first training data set, wherein the first time step is less than the second time step.

11. The method according to any one of claims 1 to 10, wherein determining the historical battery SOCs corresponding to the historical operation sampling data of the battery according to the preset ampere-hour integral ratio comprises:
defining a battery SOC corresponding to historical operation sampling data of a fully charged highest-node battery cell to be 100%; and
deducing backwards the historical operation sampling data of battery cells in different nodes by using an ampere-hour integration method, to obtain the historical battery SOCs corresponding to different historical operation sample data.

12. The method according to any one of claims 1 to 11, wherein the plurality of battery operating conditions comprise a battery charging condition, a battery idle condition, and a battery discharging condition; or
the second sample data comprise a single-cell voltage of each battery cell, a current of each battery cell, an average temperature of each battery cell, and the battery-SOC label; or
the full historical operation data of the battery comprise a charging start time, a charging end time, a charging current, a charging voltage, a temperature during charging, a discharge start time, a discharge end time, a discharge current, a discharge voltage, a depth of discharge, and a voltage and a current during the idle stage; or
a data size of the first training data and a data size of the second training data are the same.

13. A device for detecting a battery state of charge (SOC), **characterized by** comprising:
a first construction module (401) configured to construct a first battery-SOC detecting model which characterizes battery operation characteristic changing over time by taking first sample data without battery-SOC label as a first training data set, wherein the first sample data is generated based on full historical operation data of the battery, and the full historical operation data of the battery comprise operation data of the battery in a charging stage, in a discharging stage and in an idle stage during historical operation processes, and the first battery-SOC detecting model comprises a feature encoder;
a second construction module (402) configured to construct a second battery-SOC detecting model according to the feature encoder;
an extraction module (403) configured to construct second sample data carrying the battery-SOC label based on historical operation sampling data of the battery extracted from the full historical operation data of the battery, and extract features from the second sample data through the feature encoder to obtain sample feature data;
an optimization module (404) configured to iteratively optimize a feature predictor of the second battery-SOC detecting model by taking the sample feature data as a second training data set, and use the iteratively optimized second battery-SOC detecting model as the target battery-SOC detecting model, wherein the target battery-SOC detecting model is configured to characterize a correlation between battery SOC and battery operation characteristic; and
a detection module (405) configured to detect the battery SOC of a to-be-detected battery based on the target battery-SOC detecting model.

14. A computer equipment, comprising a memory and a processor, wherein the memory has a computer program stored thereon, and the processor, when executing the computer program, implements steps of the method according to any one of claims 1 to 12.

15. A non-transitory computer-readable storage medium, having a computer program stored thereon, wherein the computer program, when executed by a processor, causes the processor to implement steps of the method according to any one of claims 1 to 12.
